# EUROPEAN PATENT SPECIFICATION

(11) **EP 1 501 100 B1**
(45) Date of publication and mention of the grant of the patent: **28.11.2018**
(21) Application number: 04016660.5
(22) Date of filing: 15.07.2004
(51) Int. Cl.: G11C 16/26, G11C 7/10

(54) **Nonvolatile memory device, memory system, and operating methods**
Nichtflüchtige Speicheranordnung, Speichersystem und Betriebsverfahren
Dispositif de mémoire non volatile, système de mémoire et procédé de fonctionnement

(30) Priority: 22.07.2003 KR 2003050227; 24.05.2004 US 852841
(43) Date of publication of application: 26.01.2005
(73) Proprietor: Samsung Electronics Co., Ltd., Suwon-si, Gyeonggi-do, 443-742 (KR)
(72) Inventor: Choi, Soo-Hwan, Taeam-eup Hwaseong-gun Gyeonggi-do (KR); Park, Jung-Hoon, Taean-eup Hwaseong-si Gyeonggi-do (KR)
(74) Representative: Patentanwälte Ruff, Wilhelm, Beier, Dauster & Partner mbB

(56) References cited:
- WO-A-86/04727
- WO-A-03/030181
- WO-A2-01/75623
- US-A- 5 357 530
- US-B1- 6 222 767
- JIN-KI KIM ET AL: "A 120-mm 64-Mb NAND Flash Memory Achieving 180 ns/Byte Effective Program Speed" IEEE JOURNAL OF SOLID-STATE CIRCUITS, IEEE SERVICE CENTER, PISCATAWAY, NJ, US, vol. 32, no. 5, May 1997 (1997-05), pages 670-680, XP011060470 ISSN: 0018-9200
- YOSHIHISA IWATA ET AL: "A 35 NS CYCLE TIME 3.3 V ONLY 32 MB NAND FLASH EEPROM" IEEE JOURNAL OF SOLID-STATE CIRCUITS, IEEE SERVICE CENTER, PISCATAWAY, NJ, US, vol. 30, no. 11, 1 November 1995 (1995-11-01), pages 1157-1164, XP000553052 ISSN: 0018-9200

## Description

The invention relates to a nonvolatile memory device, in particular a flash memory device, a memory system incorporating such a device, and corresponding operating methods.

Flash memory is a type of nonvolatile rewritable memory useful in a wide variety of digital data applications that require occasional writing and/or rewriting of data, nonvolatile storage, and relatively high-speed read capability. To increase the read speed capability, some flash memory devices include a "burst-read" or "page-read" operation. A flash memory device with this capability responds to a read request by reading a "page" of memory into an on-chip buffer, and then outputting successive data elements from this buffer in response to a group of sequential read pulses.

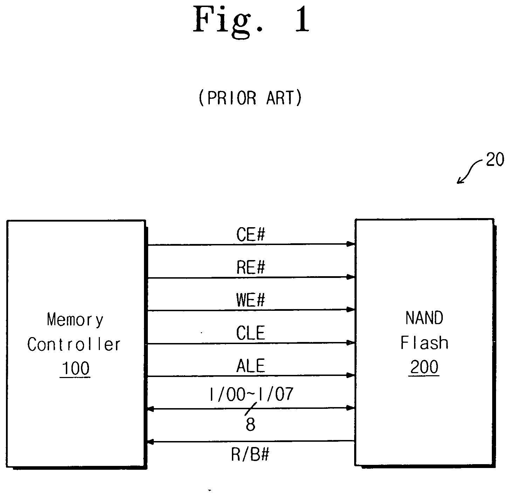

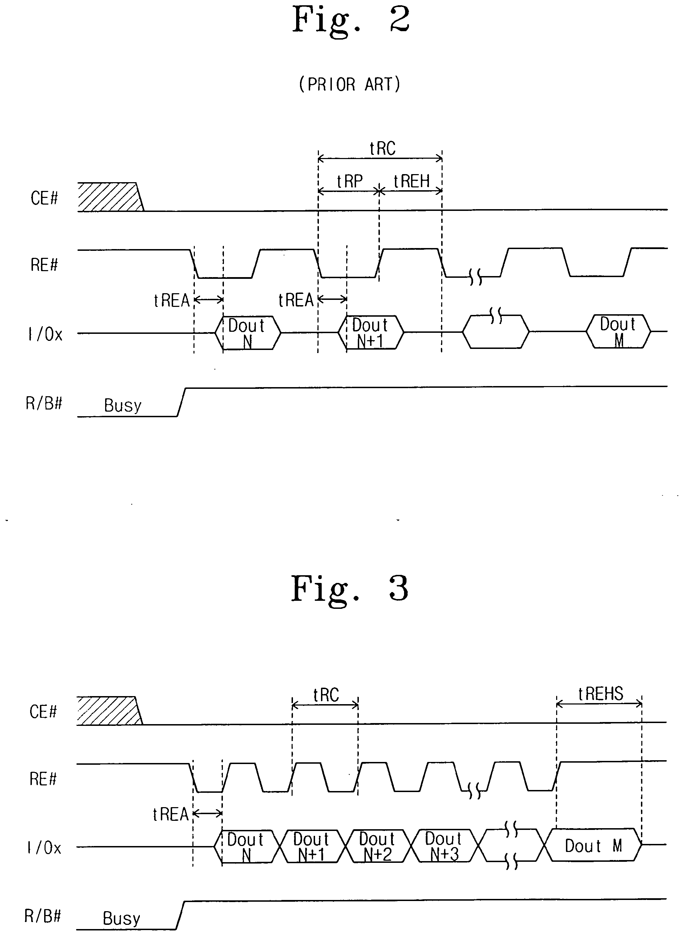

The burst read operation can be better understood with reference to Figures 1 and 2. Figure 1 illustrates a basic flash memory system 20, including a memory controller 100 and a NAND flash memory device 200. Memory controller 100 supplies control signals CE#, RE#, WE#, CLE, and ALE to memory device 200. Memory controller 100 and memory device 200 also share a bi-directional input/output (I/O) bus, shown in Figure 1 as a group of eight signal lines I/O0 - 1/07. Memory device 200 also drives an R/B# signal to memory controller 200. Of course, other implementations can have different signal lines, bus widths, and/or incorporate multiple flash memory devices, but Figure 1 illustrates basic concepts found in flash memory systems. Memory controller 100 may be a dedicated circuit or integrated into a larger circuit with additional functionality, such as a digital processor.

The control signals shown in Figure 1 operate as follows, where "#" indicates a signal that is asserted at a logic low level. Chip enable signal CE# provides selection control: other signals can be routed to multiple memory devices, and the only device that will respond is the one to which memory controller 100 asserts CE#. Read enable signal RE# actually causes memory device 200 to drive read data onto the I/O bus when asserted. Write enable signal WE# causes memory device 200 to latch address, command, or write data off of the I/O bus on a positive transition. Command latch enable signal CLE, when asserted, causes data latched at the memory device's I/O port to be interpreted as a command. Likewise, address latch enable signal ALE, when asserted, causes data latched at the memory device's I/O port to be interpreted as address data.

Input/output signals I/O0 - I/O7 are driven by memory controller 100 to transfer commands, address, and write data to memory device 200. In a read operation, I/O0 - I/O7 are driven by memory device 200 to transfer read data to memory controller 100. When memory controller 100 and flash memory device 200 are not driving the I/O bus, they each place their respective drivers in a high-impedance (high-z) state.

Finally, flash memory device 200 has the capability to drive ready/busy signal R/B# to memory controller 100. Memory device 200 pulls this signal low when it is programming, erasing, or reading from the memory array.

Figure 2 contains a timing diagram for the data transfer portion of a data read operation for system 20. Just prior to the time period depicted in Figure 2, memory controller 100 commands memory device 200 to read data for a specific page of its memory. Flash memory device 200 pulls R/B# low while the specific page is accessed from the memory array to indicate that it is busy. When R/B# returns to a high state, memory controller 100 is permitted to take RE# low (while CE# is low) to cause memory device 200 to drive a first data element Dout N onto the I/O bus. Memory controller 100 then takes RE# high as it latches Dout N off of the I/O bus. Memory device 200 then returns the I/O bus to a high-z state and awaits a new read cycle.

Several timing parameters dictate how quickly successive reads in a burst can occur. Timing parameter *tREA* represents the worst-case read-enable-to-access time, i.e., the delay
between when memory controller 100 takes RE# low and when memory device 200 begins to drive Dout *N* onto the I/O bus. Timing parameter *tRC* represents the shortest read cycle time, i.e., time between successive reads in a burst, that can be supported by the device. Parameter *tRC* generally has two sub-parameters *tRP* and *tREH* as shown. Timing parameter *tRP* represents the minimum read pulse width, i.e., time between RE# assertion and data latching. Finally, timing parameter *tREH* represents the RE# high hold time, i.e., the minimum time that memory controller 100 must hold RE# high between successive read pulses.

In general, memory controllers can support a higher bus operating speed than supported by a NAND flash memory, particularly for low-voltage flash memory. A NAND flash memory with a reduced read cycle time would therefore be advantageous in speeding overall system performance. In the conventional approach, the pulse width, *tRP,* cannot be reduced below the access time *tREA* or else the memory controller will latch erroneous data before the memory device has driven the requested data to the memory controller.

US 6,222,767 B1 discloses a non-volatile memory device according to the preamble of claim 1.

A flash memory device operating method according to the preamble of claim 17 is disclosed in Jin-Ki Kim et al., A 120-mm2 64-Mb NAND Flash Memory Achieving 180 ns/Byte Effective Program Speed, IEEE Journal of Solid-State Circuits, Vol. 32, No. 5, May 1997, page 670.

US 5,357,530 discloses a data output control circuit of a semiconductor memory device, said circuit comprising a plurality of circuit blocks each including a data output buffer controlled by an output enable signal generated by an address transition detecting circuit including an input buffer, an input signal detector, a controller, and a data output controller in series.

It is the technical problem underlying the present invention to provide for a nonvolatile memory device, a corresponding memory system, and operating methods for such device and system, which allow for improvements, especially in the data read capability compared to the prior art discussed above.

The invention solves this problem by providing for a nonvolatile flash memory device having the features of claim 1, a memory system having the features of claim 11, a flash memory device operating method having the features of claim 16, and a memory system operating method having the features of claim 19. Favorable embodiments of the invention are given in the subclaims.

The invention includes nonvolatile flash memory device embodiments, operating method embodiments, and memory system embodiments that implement what is referred to as a pipelined burst read. In the pipelined burst read, the memory controller requires two read enable assertions to read a memory cell. The first assertion causes the flash memory to drive a requested data word (where a word is defined according to the bus width) onto the data bus. The memory controller does not, however, latch the requested data word until it asserts read enable a second time. When the flash memory receives the second read enable, it is permitted to begin driving a next requested data word onto the data bus. Accordingly, a full read cycle is allowed between when a data word is requested and when the data word is expected to be valid, as opposed to a half read cycle (*tRP*) required in the prior art of Figure 2. Thus for the same bus driver characteristics, the read-enable-to-access time (*tREA*) is much less critical in the pipelined burst read than in a non-pipelined burst read, allowing the memory device to support burst rates of several times the non-pipelined burst read rate. As another advantage, some embodiments can support both non-pipelined and pipelined read operations, as instructed by the memory controller, using the same signal lines.

Advantageous embodiments are described in the following and illustrated in the drawings which also show the prior art embodiments discussed above to facilitate the understanding of the invention. In the drawings:
Figure 1 illustrates a flash memory system configuration comprising a memory controller and a NAND flash memory, useful in prior art systems and in some embodiments of the invention;
Figure 2 illustrates a prior art flash memory non-pipelined burst read operation;
Figure 3 illustrates a flash memory pipelined burst read operation according to some embodiments of the present invention;
Figure 4 contains a block diagram for a flash memory device according to some embodiments of the present invention;
Figure 5 contains a timing diagram for a complete pipelined burst read operation according to some embodiments of the present invention;
Figure 6 illustrates details for one embodiment of the control circuit of Figure 4;
Figure 7 shows one embodiment of the nRE buffer of Figure 6;
Figure 8 shows one embodiment of the judge circuit of Figure 6;
Figure 9 contains a circuit diagram for one embodiment of the multiplexer of Figure 6;
Figure 10 shows in block diagram form circuitry for setting a burst read operation mode according to some embodiments of the present invention;
Figure 11 depicts one embodiment of the Dout control circuit of Figure 6;
Figure 12 contains an exemplary circuit diagram for one bit lane of the output driver of Figure 4; and
Figure 13 contains a circuit diagram for an alternate embodiment of the Dout control circuit of Figure 6.

Figure 3 illustrates a basic pipelined burst read as implemented in some embodiments of the invention. Like in Figure 2, after a page read from the memory array completes, the memory device allows R/B# to return to a high state. The memory controller is then allowed to drive RE# low, causing the memory device to drive Dout *N* onto the I/O bus after a *tREA* access time. Unlike in Figure 2, however, the memory controller does not expect Dout *N* to be valid after a read pulse *tRP* time (when RE# is driven high). Instead, the memory controller latches Dout *N* as it asserts RE# for a second time, i.e., *tRC* after the first assertion of RE#.

When the flash memory device receives the second assertion of RE#, it begins a second access cycle, this time for Dout *N*+1. In the expected pipelined operating mode, the memory device output drivers never enter a high-z state during the burst operation, but transition directly from one data word to the next data word on successive RE# assertions. Thus Dout *N*+1 is not latched to the memory controller until a third assertion of RE#. This pattern continues for each successive data word read.

As the memory device drives each data word until a succeeding RE# pulse is received, some provision is generally required for ending the burst operation. In some embodiments, this condition is handled by returning the memory device output drivers to a high-z state if a specified maximum RE# high hold time *tREHS* is exceeded. In other words, in Figure 3, Dout M is not guaranteed to be valid if RE# has returned high for longer than *tREHS* seconds. The memory controller can handle this condition by either: a) ensuring that it latches Dout *M*, without transmitting an additional RE# pulse, after *tRC* seconds from the last RE# assertion but prior to *tREHS* seconds after the last RE# deassertion; or b) issuing an additional RE# pulse to latch Dout *M,* and then ignoring Dout *M*+1 that will be placed on the data bus due to the additional RE# pulse.

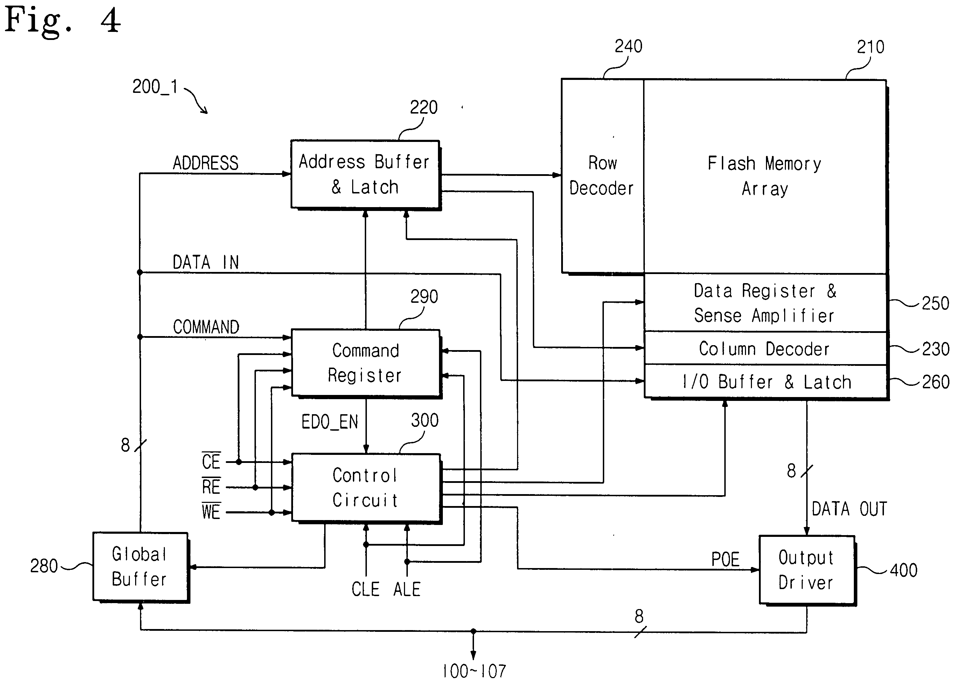

With the preceding introduction of pipelined burst read operation complete, specific circuit embodiments useful for pipelined burst read can now be described. Figure 4 shows a flash memory device 200-1 according to one embodiment of the present invention. Flash memory device 200-1 includes a flash memory array 210, address buffer and latch 220, column decoder 230, row decoder 240, data register and sense amplifier 250, I/O buffer and latch 260, global buffer 280, control circuit 300, and output driver 400.

Many of the blocks of flash memory device 200-1 function in a similar manner to their function in a prior art device. The operation of control circuit 300 and output driver 400 are modified, however, to provide a pipelined burst read operation. In some embodiments, other blocks are also modified to provide pipelined burst read operation features. The specific blocks affected by various embodiments of the invention will be described in detail, along with description of the unaffected blocks as necessary for a full understanding of the present invention. It is expected that those skilled in the art are familiar with the general operation of, for instance, flash memory cells, blocks, column and row decoders, sense amplifiers, etc., and an understanding of the detailed operation of these elements is not critical to the present invention.

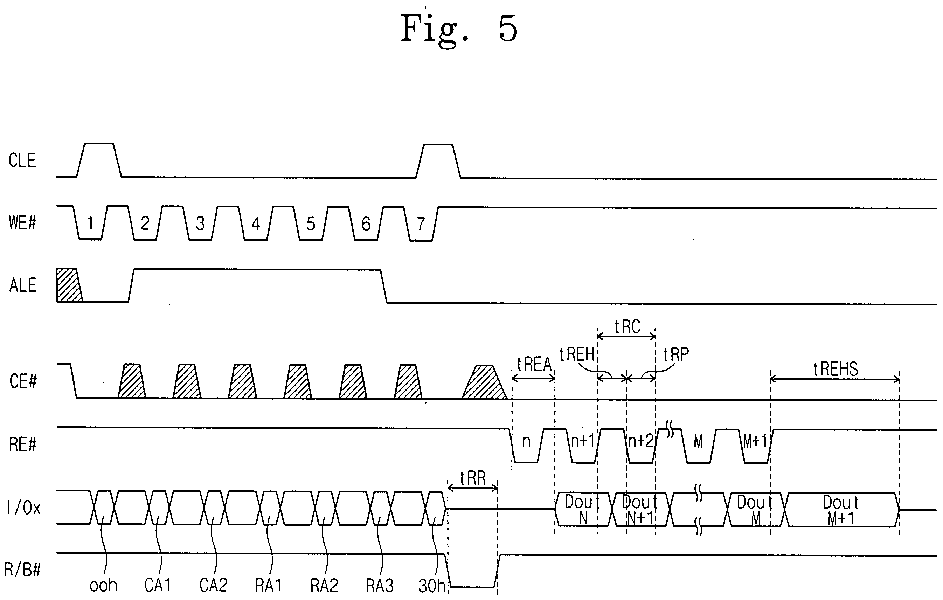

A description of a pipelined burst read operation for the flash memory device 200-1 will now be described with reference to the timing diagram of Figure 5.

Control circuit 300 latches the value present on the I/O port into global buffer 280 on a low-to-high WE# transition when CE# is low. Thus at the trailing edge of write pulse 1, a value 00h (where h indicates hexadecimal notation) is latched into global buffer 280. Also, because CLE is asserted high when this data is latched, the data is interpreted as a command and transferred from global buffer 280 to command register 290.

At the trailing edges of writes pulses 2, 3, 4, 5, and 6, CE# is low and ALE is high, indicating that the data being transferred on the I/O bus is address data. According to the address convention for this exemplary device, two cycle column address descriptors CA1 and CA2 are received for write pulses 2 and 3, respectively, and three cycle row address descriptors RA1, RA2, and RA3 are received for write pulses 4, 5, and 6, respectively. Based on ALE being asserted high, these descriptors are interpreted properly as address descriptors and transferred from global buffer 280 to address buffer and latch 220. These address format conventions can be varied from device to device based on I/O bus width, memory array row, column, and page sizes, etc.

Once the address descriptors have been loaded to address buffer and latch 220, a data operation can be performed. In Figure 5, write enable pulse 7 is used in conjunction with a second assertion of CLE to transfer a read command 30h to command register 290. In response to the read command, memory device 200-1 pulls R/B# low to indicate that it is busy, and then initiates a page read from flash memory array 210 using the supplied row address RA and column address CA. The requested page is transferred to I/O buffer and latch 260, and a word pointer in I/O buffer and latch 260 is set to the first requested address. At this time, the requested data is ready to be transferred to the memory controller. Accordingly, R/B# is allowed to return to a high value.

Some time after the memory controller senses that R/B# is high, it pulses RE# with an nth read-enable pulse while CE# is held low. Control circuit 300 interprets the falling edge of read-enable pulse *n* as a request to drive the currently pointed-to data word (Dout *N,* appearing on an internal Data Out bus) in I/O buffer and latch 260 onto the I/O bus. Control circuit responds by asserting a pipelined output enable signal POE to output driver 400. Output driver 400 responds by driving the value Dout *N* from the Data Out bus onto the I/O bus, with the data appearing *tREA* seconds after assertion n of RE#. In this example *tREA* is shown as greater than *tRP,* but this is not strictly necessary because data will not be read for at least *tRC* seconds after assertion *n* of RE#. Parameter *tREA* must, however, be less than *tRC* to ensure proper operation.

After pulsing RE# low for at least *tRP* seconds and then holding RE# high for at least *tREH* seconds, the memory controller can drive RE# low again provided at least *tRC* seconds have passed since the falling edge of read enable pulse *n.* The memory controller initiates a read-enable pulse *n*+1 while latching data Dout *N* from the I/O bus.

Control circuit 300 detects the falling edge of read-enable pulse *n*+1, and signals I/O buffer and latch 260 to increment its internal pointer to Dout *N*+1 and place Dout *N*+1 on the Data Out bus. Internal pipelined output enable signal remains asserted during this operation, such that output driver 400 transitions to driving Dout *N*+1 without ever entering a high-z state.

Assuming that read-enable pulse *n*+1 has met the conditions described above for a valid read-enable pulse *n,* the memory controller can drive a new read enable pulse *n+2* to the memory device. The memory controller can latch data Dout *N*+1 from the I/O bus while initiating read enable pulse *n*+2.

The pipelined burst read operation can continue in this manner until the memory controller has received the last data value that it needs (either Dout *M* or Dout *M*+1). The following description illustrates at least one method for ending the pipelined burst read operation.

Approximately simultaneously with the falling edge of an *m*+1*th* read-enable pulse, the memory controller latches Dout *M* from the I/O bus. The memory device interprets the *m*+1*th* read-enable pulse as a request, intended or not, for it to drive Dout *M*+1 onto the I/O bus. The memory device thus drives Dout *M*+1 onto the I/O bus and awaits an *m*+2*th* read-enable pulse that is not forthcoming.

The memory controller can choose to ignore Dout *M*+1, or to latch Dout *M*+1 if it can do so during the data valid period without initiating an *m*+2*th* read-enable pulse. Meanwhile, control circuit 300 has detected the rising edge of the *m*+1*th* read-enable pulse and is marking the passage of time. Once a time period *tREHS* passes without an *m*+2*th* read-enable pulse falling edge being detected, control circuit 300 deasserts POE, causing output driver 400 to enter a high-z state. The memory controller need only hold RE# high for *tREHS* seconds to ensure that the memory device has released the I/O bus, and then the memory controller can initiate a new command.

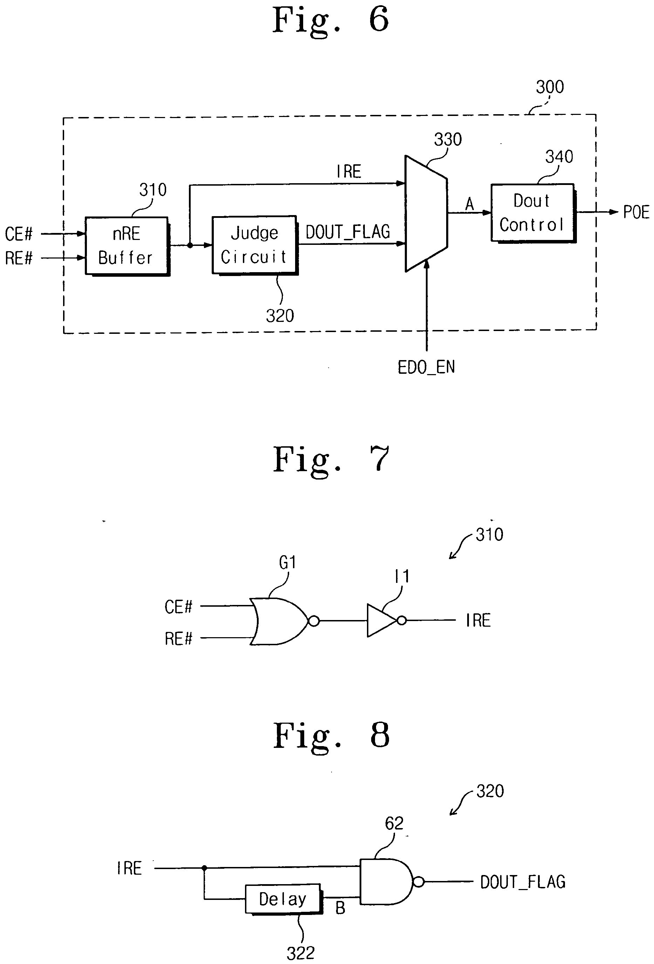

Figure 6 illustrates the portion of the circuitry, within control circuit 300, that is used to generate the POE output enable signal to output driver 400 in some embodiments of the present invention. To this end, control circuit 300 comprised an nRE buffer 310 to generate an internal read enable signal IRE based on CE# and RE#, a judge circuit 320 that receives IRE as its input, a 2:1 multiplexer 330 to select one of IRE and the output of judge circuit 320 based on a mux select signal EDO_EN, and a Dout (Data out) control circuit 340 to create output enable signal POE based, at least in part, on the output of multiplexer 330. The function of each of these blocks will be described in turn.

Figure 7 shows one embodiment of nRE buffer 310, comprising a two-input NOR gate G1, an inverter I1. The external signals CE# and RE# are coupled, respectively, to the two inputs of NOR gate G1. The output of NOR gate G1 is supplied to the input of inverter I1, and the output of inverter I1 is supplied as internal read enable signal IRE.

In operation, IRE is asserted low whenever both CE# and RE# are asserted low. Assuming that CE# is held low by the memory controller for the duration of an RE# pulse, IRE will mirror RE#.

Figure 8 shows one embodiment of judge circuit 320, comprising a delay element 322 and a two-input NAND gate G2. Internal read enable signal IRE is supplied as an input to delay element 322 and as one input to NAND gate G2. The output of delay element 322, shown as signal "B," is supplied as the second input to NAND gate G2. NAND gate G2 generates a signal DOUT_FLAG.

In operation, DOUT_FLAG remains asserted high as long as at least one of IRE and B is low. Assuming that IRE has been high for longer than the delay period, this circuit responds to IRE going low by driving DOUT_FLAG high. Assuming that the delay of element 322 is shorter than the low pulse on IRE, signal B will go low before IRE returns to high, thus holding DOUT_FLAG high. If IRE is again pulsed low before signal B follows IRE high, DOUT_FLAG remains high. Under these conditions, DOUT_FLAG will stay high indefinitely as long as IRE continues to toggle, and will only return to a low value if signal IRE returns high and stays high for longer than the delay period of element 322.

Other embodiments of judge circuit 322 are possible. Functionally, the judge circuit should enable the data output upon receiving a first read enable pulse, and continue to enable the data output as long as the read enable signal continue to toggle at least once in a period *tREHS.* When an entire period *tREHS* is observed without a new read enable signal appearing, the judge circuit changes its state to low. The length of period *tREHS* is a design parameter that can be set to provide correct operation in a desired range of read cycle times.

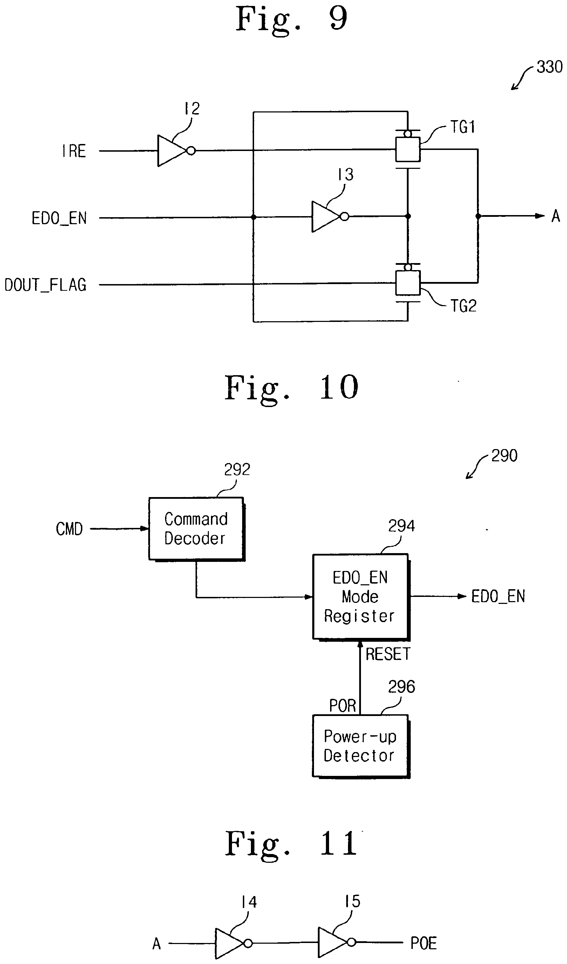

Figure 9 illustrates one embodiment of multiplexer 330, including inverters 12 and 13 and transmission gates TG1 and TG2. 12 inverts input signal IRE and supplies the inverted signal to the input of transmission gate TG1. Input signal DOUT_FLAG is supplied to the input of transmission gate TG2. The outputs of transmission gates TG1 and TG2 are tied together at an output A.

13 inverts the control signal EDO_EN. EDO_EN and the inverter 13 output are supplied to the control gates of TG1 such that TG1 passes its input to output A when EDO_EN is low. EDO_EN and the inverter 13 output are supplied in complementary fashion to the control gates of TG2 such that TG2 passes its input to output A when EDO_EN is high. Accordingly, EDO_EN selects either IRE (inverted) or DOUT_FLAG as output A.

EDO_EN can be used advantageously to switch between two burst read operating modes. When EDO_EN is low, burst read operations similar to the prior art are performed. When EDO_EN is high, pipelined burst read operations are performed.

Several methods can be used to control EDO_EN. In a simple approach, a dedicated external memory device pin can be tied to *V_{CC}* or *V_{SS}*, or tied to a switchable input. Preferably, however, EDO_EN can be controlled from the memory controller using the existing signal lines. In one approach, shown in Figure 10, command register 290 contains a command decoder 292, an EDO_EN mode register 294, and a power-up detector 296. Power-up detector 296 generates a POR signal during the power-up period. The POR signal sets EDO_EN mode register 294 to a logic low state (or, if desired in a particular application, a logic high state), such that the device is in a determinate burst read mode state. Subsequently, if command decoder 292 receives a command signal CMD indicating that the memory controller desires to use a first burst read operation type, command decoder 292 sets EDO_EN mode register 294 to a logic low state. Also, if command decoder 292 receives a command signal CMD indicating that the memory controller desires to use a second burst read operation type, command decoder 292 sets EDO_EN mode register 294 to a logic high state. The command signal CMD can be a dedicated mode-setting command. Alternately, two different read command types can be used; when the memory controller issues the first read command type, EDO_EN mode register 294 is set to a logic low state, and when the memory controller issues the second read command type EDO_EN mode register 294 is set to a logic high state.

Figure 11 illustrates one embodiment of Dout control circuit 340 shown in Figure 6. In this simple embodiment, Dout control circuit 340 consists of two serial inverters 14 and 15, which merely buffer output A from multiplexer 330 to provide output enable signal POE. Thus when multiplexer 330 selects inverted IRE, output enable POE is high when both CE# and RE# are low, and low otherwise. The output driver is thus controlled according to Figure 2, having a DATA state when RE# is low (and the chip is selected) and a high-z state otherwise. When multiplexer 330 selects DOUT_FLAG, output enable POE transitions to high when both CE# and RE# are low, placing the output driver in a DATA state. POE persists in a high state as long as RE# toggles (while the chip is selected) within a time *tREHS.* POE continues to persist in a high state for *tREHS* seconds after the last positive transition of RE#, and then reverts to a low state (placing the output driver in a high-z state).

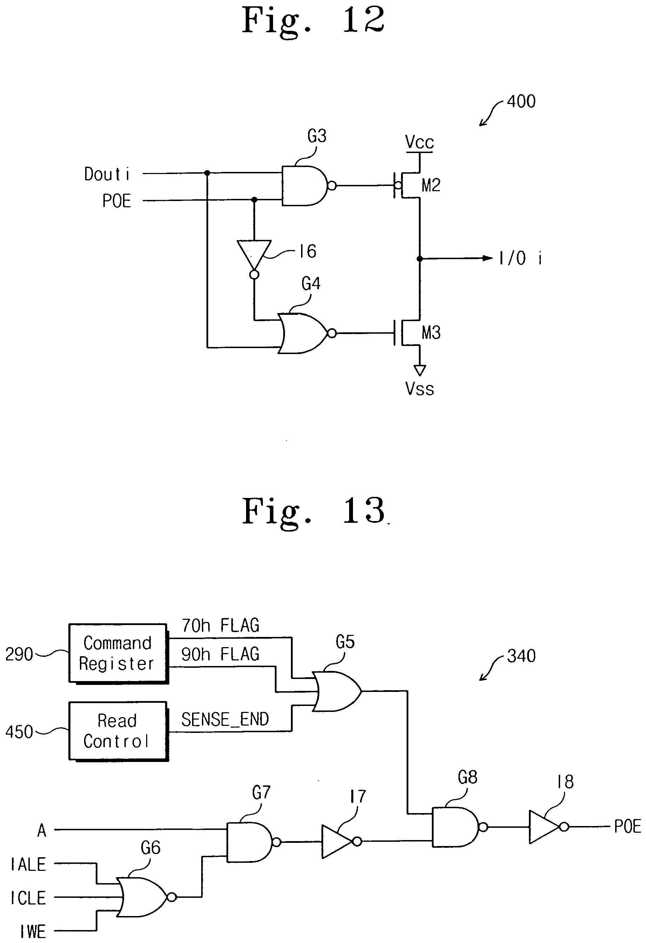

Figure 12 illustrates one possible implementation of one bit lane i of output driver 400, with other bit lanes implemented in similar fashion. Bit lane i output driver comprises a two-input NAND gate G3, an inverter 16, a two-input NOR gate G4, a p-channel drive transistor M2, and an n-channel driver transistor M3. Data out bit lane value Dout*i* from I/O buffer and latch 260 is supplied to one input of gates G3 and G4. Output enable POE from control circuit 300 is supplied to the other input of NAND gate G3, and to the input of inverter 16. The output of inverter 16 is supplied as the second input to NOR gate G4.

The output of NAND gate G3 drives the gate of p-channel drive transistor M2, and the output of NOR gate G4 drives the gate of n-channel drive transistor M3. P-channel drive transistor M2 has its source connected to *V_{CC}* and its drain connected to input/output bus line I/O*i*. N-channel drive transistor M3 has its source connected to *V_{SS}* and its drain connected to input/output bus line I/O*i*. Accordingly, when M2 is on I/O*i* is pulled high, when M3 is on I/O is pulled low, and when M2 and M3 are both off the output driver is in a high-z state.

The output driver circuit operates as follows. When POE is low, NAND gate G3 has a high output no matter what the state of Dout*i*, and thus p-channel drive transistor M2 is off. Also when POE is low, NOR gate G4 has a low output no matter what the state of Dout*i*, and thus n-channel drive transistor M3 is also off, and the output driver is in a high-z state.

When POE is high, driver output is determined by Dout*i*. Thus when Dout*i* is also high, NAND gate G3 generates a low output, causing drive transistor M2 to pull I/O*i* high. And when Dout*i* is low, NOR gate G4 generates a high output, causing drive transistor M3 to pull I/O*i* low. As POE can be controlled according to either pipelined or non-pipelined burst modes, output driver 400 can support both modes as well.

Many of the functional blocks described above can incorporate other functionality. For instance, Dout control 340 shown in Figure 6 can use other state information to control POE in addition to multiplexer 330 output A. Figure 13 illustrates such an embodiment, comprising a three-input OR gate G5, a three-input NOR gate G6, two two-input NAND gates G7 and G8, and two inverters 17 and 18.

In Figure 13, POE is disabled until output data is ready. In a normal read from flash memory array 210, a read control circuit 450 indicates that data is available by asserting a signal SENSE_END. Also, the memory controller can issue a 70h command to request state information, e.g., did the last program or erase function complete normally. Since this data does not have to be read from the memory array, command register 290 can assert a 70h flag to indicate that the state information is ready to be driven on the I/O bus. The memory controller can also issue a 90h command to request device ID information such as a maker code, device code, chip number, cell type, page size and spare size, and data organization. Since this data does not have to be read from the memory array, command register 290 can assert a 90h flag to indicate that the ID information is ready to be driven on the I/O bus.

OR gate G5 ors the 70h flag, 90h flag, and SENSE_END signals. NAND gate G8 with serial inverter I8 and the output of OR gate G5 with what would otherwise be the POE signal to produce a POE signal that cannot be asserted unless one of the 70h flag, 90h flag, and SENSE_END signals is asserted. Accordingly, the output drivers remain in a high-z state if the memory controller requests a read operation when data is not ready to be transferred.

Dout control 340 of Figure 13 also contains circuitry to disable POE when the memory controller is attempting to drive data on the I/O bus. NOR gate G6 ors internal address latch enable signal IALE, internal command latch enable signal ICLE, and internal write enable signal IWE, and supplies its output to one input of NAND gate G7 with serial inverter 17. Multiplexer 330 output signal A is supplied to the other input of NAND gate G7. Accordingly, POE is disabled when the memory controller is attempting to drive data on the I/O bus.

The above embodiments are merely exemplary. Other flash memory features not described herein can be combined with the above embodiments. Not all features shown above need exist in every embodiment. For instance, multiplexer 330 and its associated circuitry are not needed when the flash memory device does not need to support a non-pipelined burst read operation. The particular partitioning of circuit functionality shown is illustrative of one approach, but other architectural arrangements are also possible.

Many alternate implementations exist for the exemplary components described herein. Such minor modifications and implementation details are encompassed within the embodiments of the invention, and are intended to fall within the scope of the claims.

The preceding embodiments are exemplary. Although the specification may refer to "an", "one", "another", or "some" embodiment(s) in several locations, this does not necessarily mean that each such reference is to the same embodiment(s), or that the feature only applies to a single embodiment.

## Claims

1. A nonvolatile flash memory device, comprising
an output buffer (260) configured to supply a data out signal in response to an assertion of a read enable signal; and
a tri-state output driver (400) coupled to the data out signal and an output enable signal, and configured to drive the data out signal onto an output node when the output enable signal is asserted, the tri-state output driver presenting a high impedance at the output node otherwise,
**characterized by**
a judge circuit (320) to assert an output flag signal in response to the assertion of the read enable signal, the judge circuit deasserting the output flag signal when the read enable signal remains deasserted for at least a hold time, wherein in at least one read mode the output enable signal is responsive to the output flag signal; and
a multiplexer (330) having a multiplexer output that is selectable, based on a read mode input signal, from a first and a second signal input, the first signal input coupled to the output flag signal, and the second input coupled to the read enable signal, wherein the output enable signal is responsive to the multiplexer output.

2. The nonvolatile flash memory device of claim 1, wherein the multiplexer comprises:
a first transmission gate having an input connected to the first signal input, an output connected to the multiplexer output, and a control gate connected to turn the first transmission gate on when the read mode input signal is in a first logic state; and
a second transmission gate having an input connected to the second signal input, an output connected to the multiplexer output, and a control gate connected to turn the second transmission gate on when the read mode input signal is in a second logic state.

3. The nonvolatile flash memory device of claim 1 or 2, further comprising a programmable mode register to generate the read mode input signal.

4. The nonvolatile flash memory device of claim 3, wherein the programmable mode register is programmable in response to a mode register command received by the device during operation, the programmable mode register having reset logic to set the register state upon device power-up.

5. The nonvolatile flash memory device of any of claims 1 to 4, further comprising a data output control circuit to receive the multiplexer output and generate the output enable signal.

6. The nonvolatile flash memory device of claim 5, having the capability to perform register read operations and data array read operations, wherein the data output control circuit allows the output enable signal to respond to the multiplexer output both when a register read is requested and when an array read is requested and array data is ready for output as the data out signal.

7. The nonvolatile flash memory device of any of claims 1 to 6, further comprising a read enable buffer to assert the read enable signal when an external chip enable signal and an external read enable signal are both asserted.

8. The nonvolatile flash memory device of any of claims 1 to 5, further comprising:
a programmable mode circuit (290) to generate a read mode input signal capable of indicating at least two read modes, including a pipelined read mode and a non-pipelined read mode; and
a control circuit (300) to generate the output enable signal based on the read mode input signal and the read enable signal, wherein in the non-pipelined read mode a deassertion of the output enable signal is triggered in response to a deassertion of the read enable signal, and wherein in the pipelined read mode a deassertion of the output enable signal is triggered by the read enable signal remaining deasserted for the hold time.

9. The nonvolatile flash memory device of claim 8, wherein the programmable mode circuit is programmable via mode register set commands received by the nonvolatile memory device during operation.

10. The nonvolatile flash memory device of claim 8 or 9, wherein the programmable mode circuit defaults to generating a read mode input signal indicative of the non-pipelined read mode upon flash memory device power-up or defaults to generating a read mode input signal indicative of the pipelined read mode upon flash memory device power-up.

11. A memory system comprising:
a memory controller having a read enable output that is asserted to a device to cause the device to transmit read data to the memory controller;
a multiplexed memory bus to transmit address, command, and write data from the memory controller and to transmit read data to the memory controller; and
a nonvolatile flash memory (200-1) device according to any of claims 1 to 10 connected to the multiplexed memory bus and to the read enable output signal, and having a pipelined burst read mode; wherein
the flash memory device is configured to transmit read data n to the memory controller until a set time after receiving an *n*+1th assertion of the read enable output, at which time the flash memory device begins transmitting read data n+1 to the memory controller, and
the flash memory device is configured to stop transmitting read data n to the memory controller and releases the multiplexed memory bus when an *n*+1th assertion of the read enable output is not received within a hold time after the *n*th deassertion of the read enable output.

12. The memory system of claim 11, wherein the flash memory device has a memory array having a NAND storage node array structure.

13. The memory system of claim 11 or 12, wherein the flash memory device also has a non-pipelined burst read mode, wherein the flash memory device has the capability to operate in either the pipelined or the non-pipelined burst read mode.

14. The memory system of claim 13, wherein the memory controller has the capability to transmit commands to the flash memory device to select either the pipelined or the non-pipelined burst read mode.

15. The memory system of claim 13 or 14, wherein the flash memory device defaults to the non-pipelined burst read mode upon power-up or defaults to the pipelined burst read mode upon power-up.

16. A method for operating a flash memory device, said flash memory device comprising an output buffer (260) to supply a data out signal in response to an assertion of a read enable signal, a judging circuit (320) to assert an output flag signal in response to the assertion of the read enable signal, the judging circuit deasserting the output flag signal when the read enable signal remains deasserted for at least a hold time, a tri-state output driver (400) coupled to the data out signal and an output enable signal, the tri-state output driver driving and configured to drive the data out signal onto an output node when the output enable signal is asserted, and presenting a high impedance at the output node otherwise, and a multiplexer (330), the method comprising:
in a first read mode, in response to a first read enable assertion, driving a requested data word at a flash memory device output until a second read enable assertion causes the device to drive a next requested data word onto the flash memory device output, where the flash memory device output is placed in a high impedance state on the deassertion of the second read enable assertion, and
in a second read mode, in response to a first read enable assertion, driving a requested data word at a flash memory device output until a second read enable assertion causes the device to drive a next requested data word onto the flash memory device output, where the flash memory device output is placed in a high impedance state on the expiry of a hold time after the deassertion of the second (n-th) read enable assertion.

17. The method of claim 16, further comprising selecting the first or second read mode in response to a mode register set command.

18. The method of claim 16 or 17, further comprising selecting the second read mode as a default mode upon device power-up.

19. A method for operating a memory system according to any of claims 11 to 15, the method comprising to operate the flash memory device by the method of any of claims 16 to 18 such that
the memory controller asserts a read enable signal an nth time to the flash memory device;
the memory controller deasserts the read enable signal an *n*th time;
the flash memory device places read data *n* on the bus in response to read enable signal assertion *n;*
the memory controller asserts the read enable signal an *n*+1th time to the flash memory device and reading read data *n* off of the bus;
the memory controller deasserts the read enable signal an *n*+1th time;
the flash memory device replaces read data *n* with read data *n*+1 on the bus in response to read enable signal assertion *n*+1;
the memory controller reads read data *n*+1 off of the bus; and
the flash memory device removes read data *n*+1 from the bus and placing the device's bus connection in a high-impedance state a hold time after receiving read enable signal deassertion *n*+1.

20. The method of claim 19, further comprising additional read enable signal assertions and deassertions arranged with the *n*th and *n*+1th assertions and deassertions in a common burst read operation.

21. The method of claim 19 or 20, further comprising:
initiating a command at the memory controller some time prior to the *n*th read enable signal assertion to request a pipelined read operation mode; and
configuring the memory device to operate according to claim 18 in response to the command.

## Patentansprüche

1. Nicht-flüchtiges Flash-Speicherbauelement mit
- einem Ausgabepuffer (260), der dafür eingerichtet ist, ein Datenausgabesignal in Reaktion auf eine Bestätigung eines Lesefreigabesignals bereitzustellen, und
- einem Dreizustands-Ausgabetreiber (400), der an das Datenausgabesignal und ein Ausgabefreigabesignal gekoppelt und dafür eingerichtet ist, das Datenausgabesignal auf einem Ausgabeknoten zu treiben, wenn das Ausgabefreigabesignal bestätigt wird, wobei der Dreizustands-Ausgabetreiber ansonsten eine hohe Impedanz am Ausgangsknoten aufweist, **gekennzeichnet durch**
- einen Beurteilungsschaltkreis (320), um ein Ausgabemarkierungssignal in Reaktion auf die Bestätigung des Lesefreigabesignals zu bestätigen und die Bestätigung des Ausgabemarkierungssignals aufzuheben, wenn die Bestätigung des Lesefreigabesignals mindestens für eine Haltezeit aufgehoben bleibt, wobei in wenigstens einem Lesemodus das Ausgabefreigabesignal auf das Ausgabemarkierungssignal reagiert, und
- einen Multiplexer (330) mit einer Multiplexerausgabe, die basierend auf einem Lesemoduseingabesignal aus einer ersten und einer zweiten Signaleingabe auswählbar ist, wobei die erste Signalausgabe mit dem Ausgabemarkierungssignal gekoppelt ist, die zweite Signaleingabe mit dem Lesefreigabesignal gekoppelt ist und das Ausgabefreigabesignal auf die Multiplexerausgabe anspricht.

2. Nicht-flüchtiges Flash-Speicherbauelement nach Anspruch 1, wobei der Multiplexer Folgendes aufweist:
- ein erstes Übertragungsgatter mit einem mit der ersten Signaleingabe verbundenen Eingang, einem mit der Multiplexerausgabe verbundenen Ausgang und einem Steuergate, das zum Einschalten des ersten Übertragungsgatters, wenn sich das Lesemoduseingabesignal in einem ersten Logikzustand befindet, verschaltet ist, und
- ein zweites Übertragungsgatter mit einem mit der zweiten Signaleingabe verbundenen Eingang, einem mit der Multiplexerausgabe verbundenen Ausgang und einem Steuergate, das zum Einschalten des zweiten Übertragungsgatters, wenn sich das Lesemoduseingabesignal in einem zweiten Logikzustand befindet, verschaltet ist.

3. Nicht-flüchtiges Flash-Speicherbauelement nach Anspruch 1 oder 2, das des Weiteren ein programmierbares Modusregister zur Erzeugung des Lesemoduseingabesignals aufweist.

4. Nicht-flüchtiges Flash-Speicherbauelement nach Anspruch 3, wobei das programmierbare Modusregister in Reaktion auf einen von dem Bauelement während des Betriebs empfangenen Modusregisterbefehl programmierbar ist und eine Rücksetzlogik zum Setzen des Registerstatus beim Anschalten des Bauelements besitzt.

5. Nicht-flüchtiges Flash-Speicherbauelement nach einem der Ansprüche 1 bis 4, das des Weiteren einen Datenausgabesteuerschaltkreis zum Empfangen der Multiplexerausgabe und Erzeugen des Ausgabefreigabesignals aufweist.

6. Nicht-flüchtiges Flash-Speicherbauelement nach Anspruch 5, das zur Durchführung von Registerlesevorgängen und Datenarraylesevorgängen befähigt ist, wobei es der Datenausgabeschaltkreis dem Ausgabefreigabesignal ermöglicht, auf die Multiplexerausgabe sowohl dann, wenn ein Registerlesevorgang angefordert wird, als auch dann zu reagieren, wenn ein Arraylesevorgang angefordert wird und Arraydaten zur Ausgabe als das Datenausgabesignal bereitstehen.

7. Nicht-flüchtiges Flash-Speicherbauelement nach einem der Ansprüche 1 bis 6, das des Weiteren einen Lesefreigabepuffer zum Bestätigen des Lesefreigabesignals aufweist, wenn sowohl ein externes Chipfreigabesignal als auch ein externes Lesefreigabesignal bestätigt werden.

8. Nicht-flüchtiges Flash-Speicherbauelement nach einem der Ansprüche 1 bis 5, das des Weiteren Folgendes aufweist:
- einen programmierbaren Modusschaltkreis (290) zur Erzeugung eines Lesemoduseingabesignals, das zum Anzeigen von wenigstens zwei Lesemodi befähigt ist, einschließlich eines Pipeline-Lesemodus und eines Nicht-Pipeline-Lesemodus, und
- einen Steuerschaltkreis (300) zur Erzeugung des Ausgabefreigabesignals basierend auf dem Lesemoduseingabesignal und dem Lesefreigabesignal, wobei im Nicht-Pipeline-Lesemodus eine Aufhebung der Bestätigung des Ausgabefreigabesignals in Reaktion auf eine Aufhebung der Bestätigung des Lesefreigabesignals getriggert wird und im Pipeline-Lesemodus eine Aufhebung der Bestätigung des Ausgabefreigabesignals dadurch getriggert wird, dass die Bestätigung des Lesefreigabesignals während der Haltezeit aufrechterhalten bleibt.

9. Nicht-flüchtiges Flash-Speicherbauelement nach Anspruch 8, wobei der programmierbare Modusschaltkreis über Modusregistersetzbefehle programmierbar ist, die während des Betriebs von dem nicht-flüchtigen Flash-Speicherbauelement empfangen werden.

10. Nicht-flüchtiges Flash-Speicherbauelement nach Anspruch 8 oder 9, wobei der programmierbare Modusschaltkreis zum Erzeugen eines Lesemoduseingabesignals, das für den Nicht-Pipeline-Lesemodus indikativ ist, beim Einschalten des Flash-Speicherbauelements voreingestellt ist oder zur Erzeugung eines Lesemoduseingabesignals, das für den Pipeline-Lesemodus indikativ ist, beim Einschalten des Flash-Speicherbauelements voreingestellt ist.

11. Speichersystem mit
- einer Speichersteuerung mit einer Lesefreigabeausgabe, die einem Bauelement bestätigt wird, um das Bauelement zum Übertragen von Lesedaten an die Speichersteuerung zu veranlassen,
- einem Multiplex-Speicherbus zum Übertragen von Adress-, Befehls- und Schreibdaten von der Speichersteuerung und zum Übertragen von Lesedaten an die Speichersteuerung und
- einem nicht-flüchtigen Flash-Speicherbauelement (200-1) nach einem der Ansprüche 1 bis 10, das mit dem Multiplex-Speicherbus und mit dem Lesefreigabeausgabesignal verbunden ist und einen Pipeline-Bündellesemodus aufweist,
- wobei das Flash-Speicherbauelement dafür eingerichtet ist, Lesedaten n an die Speichersteuerung bis zu einer Setzzeit nach Empfangen einer (n+1)-ten Bestätigung der Lesefreigabeausgabe zu übertragen, wobei zu diesem Zeitpunkt das Flash-Speicherbauelement damit beginnt, Lesedaten (n+1) an die Speichersteuerung zu übertragen, und
- wobei das Flash-Speicherbauelement dafür eingerichtet ist, die Übertragung der Lesedaten n an die Speichersteuerung zu stoppen und den Multiplex-Speicherbus freizugeben, wenn keine (n+1)-te Bestätigung der Lesefreigabeausgabe innerhalb einer Haltezeit nach der n-ten Aufhebung der Bestätigung der Lesefreigabeausgabe empfangen wird.

12. Speichersystem nach Anspruch 11, wobei das Flash-Speicherbauelement ein Speicherfeld mit einer NAND-Speicherknotenarraystruktur aufweist.

13. Speichersystem nach Anspruch 11 oder 12, wobei das Flash-Speicherbauelement zusätzlich einen Nicht-Pipeline-Burstlesemodus besitzt und die Fähigkeit hat, entweder im Pipeline- oder im Nicht-Pipeline-Burstlesemodus zu arbeiten.

14. Speichersystem nach Anspruch 13, wobei die Speichersteuerung die Fähigkeit besitzt, Befehle an das Flash-Speicherbauelement zu übertragen, um entweder den Pipeline- oder den Nicht-Pipeline-Burstlesemodus auszuwählen.

15. Speichersystem nach Anspruch 13 oder 14, wobei das Flash-Speicherbauelement auf den Nicht-Pipeline-Burstlesemodus beim Einschalten voreingestellt ist oder auf den Pipeline-Burstlesemodus beim Einschalten voreingestellt ist.

16. Verfahren zum Betrieb eines Flash-Speicherbauelements, wobei das Flash-Speicherbauelement einen Ausgabepuffer (260) zum Bereitstellen eines Datenausgabesignals in Reaktion auf eine Bestätigung eines Lesefreigabesignals, einen Beurteilungsschaltkreis (320) zum Bestätigen eines Ausgabemarkierungssignals in Reaktion auf die Bestätigung des Lesefreigabesignals, wobei der Beurteilungsschaltkreis die Bestätigung des Ausgabemarkierungssignals aufhebt, wenn die Aufhebung des Lesefreigabesignals mindestens für eine Haltezeit andauert, einen Dreizustands-Ausgabetreiber (400), der an das Datenausgabesignal und ein Ausgabefreigabesignal gekoppelt ist und zum Treiben dient und dafür eingerichtet ist, das Datenausgabesignal auf einem Ausgangsknoten zu treiben, wenn das Ausgabefreigabesignal bestätigt wird, und andernfalls eine hohe Impedanz am Ausgabeknoten aufweist, und einen Multiplexer (330) umfasst, wobei das Verfahren Folgendes beinhaltet:
- in einem ersten Lesemodus Treiben eines angeforderten Datenwortes an einem Flash-Speicherbauelementausgang in Reaktion auf eine erste Lesefreigabebestätigung, bis eine zweite Lesefreigabebestätigung das Bauelement veranlasst, ein nächstes angefordertes Datenwort auf dem Flash-Speicherbauelementausgang zu treiben, wobei der Flash-Speicherbauelementausgang auf die Aufhebung der zweiten Lesefreigabebestätigung in einen hohen Impedanzzustand gebracht wird, und
- in einem zweiten Lesemodus Treiben eines angeforderten Datenwortes an einem Flash-Speicherbauelementausgang in Reaktion auf eine erste Lesefreigabebestätigung, bis eine zweite Lesefreigabebestätigung das Bauelement veranlasst, ein nächstes angefordertes Datenwort auf dem Flash-Speicherbauelementausgang zu treiben, wobei der Flash-Speicherbauelementausgang bei Ablauf einer Haltezeit nach Aufhebung der zweiten (n-ten) Lesefreigabebestätigung in einen hohen Impedanzzustand versetzt wird.

17. Verfahren nach Anspruch 16, das des Weiteren ein Auswählen des ersten oder zweiten Lesemodus in Reaktion auf einen Modusregistersetzbefehl umfasst.

18. Verfahren nach Anspruch 16 oder 17, das des Weiteren ein Auswählen des zweiten Lesemodus als einen voreingestellten Modus beim Einschalten des Bauelements umfasst.

19. Verfahren zum Betrieb eines Speichersystems nach einem der Ansprüche 11 bis 15, wobei das Verfahren einen Betrieb des Flash-Speicherbauelements gemäß dem Verfahren nach einem der Ansprüche 16 bis 18 derart umfasst, dass
- die Speichersteuerung ein Lesefreigabesignal ein n-tes Mal dem Flash-Speicherbauelement bestätigt,
- die Speichersteuerung die Bestätigung des Lesefreigabesignals ein n-tes Mal aufhebt,
- das Flash-Speicherbauelement Lesedaten n auf dem Bus in Reaktion auf eine Lesefreigabesignalbestätigung n platziert,
- die Speichersteuerung das Lesefreigabesignal ein (n+1)-tes Mal dem Flash-Speicherbauelement bestätigt und Lesedaten n von dem Bus herunterliest,
- die Speichersteuerung die Bestätigung des Lesefreigabesignals ein (n+1)-tes Mal aufhebt,
- das Flash-Speicherbauelement Lesedaten n auf dem Bus durch Lesedaten n+1 in Reaktion auf die Lesefreigabesignalbestätigung n+1 ersetzt,
- die Speichersteuerung Lesedaten n+1 von dem Bus herunterliest und
- das Flash-Speicherbauelement Lesedaten n+1 von dem Bus entfernt und seine Busverbindung eine Haltezeit nach Empfangen der Aufhebung des Lesefreigabesignals n+1 in einen hohen Impedanzzustand versetzt.

20. Verfahren nach Anspruch 19, das des Weiteren zusätzliche Lesefreigabesignalbestätigungen und Lesefreigabesignalbestätigungsaufhebungen in Verbindung mit den n-ten und (n+1)-ten Bestätigungen und Bestätigungsaufhebungen in einem gemeinsamen Bündellesevorgang beinhaltet.

21. Verfahren nach Anspruch 19 oder 20, das des Weiteren Folgendes umfasst:
- Initialisieren eines Befehls an der Speichersteuerung einige Zeit vor der n-ten Lesefreigabesignalbestätigung, um einen Pipeline-Lesebetriebsmodus anzufordern, und
- Konfigurieren des Speicherbauelements für einen Betrieb gemäß Anspruch 18 in Reaktion auf den Befehl.

## Revendications

1. Dispositif de mémoire flash non volatile, comprenant
un tampon de sortie (260) configuré pour fournir un signal de sortie de données en réponse à une assertion d'un signal d'autorisation de lecture ; et
un driver de sortie tri-état (400) accouplé au signal de sortie de données et un signal d'autorisation de sortie, et configuré pour conduire le signal de sortie de données sur un noeud de sortie lorsque le signal d'autorisation de sortie est affirmé, le driver de sortie tri-état présentant une haute impédance au noeud de sortie autrement,
**caractérisé par**
un circuit de jugement (320) pour affirmer un signal de flag de sortie en réponse à l'assertion du signal d'autorisation de lecture, le circuit de jugement pour déaffirmer le signal de flag de sortie lorsque le signal d'autorisation de lecture reste déaffirmé pendant au moins un temps de maintien, dans lequel dans au moins un mode de lecture le signal d'autorisation de sortie est responsive au signal de flag de sortie ; et
un multiplexeur (330) avec une sortie de multiplexeur sélectionnable, basé sur un signal d'entrée de mode de lecture, d'une première et une deuxième entrée de signal, la première entrée de signal accouplée au signal de flag de sortie, et la deuxième entrée de signal accouplée au signal d'autorisation de lecture, dans lequel le signal d'autorisation de sortie est responsive à la sortie de multiplexeur.

2. Dispositif de mémoire flash non volatile selon la revendication 1, dans lequel le multiplexeur comprend :
une première grille de transmission ayant une entrée connectée à la première entrée de signal, une sortie connectée à la sortie de multiplexeur, et une grille de commande connectée pour activer la première grille de transmission lorsque le signal d'entrée de mode de lecture se trouve dans un premier état logique ; et
une deuxième grille de transmission ayant une entrée connectée à la deuxième entrée de signal, une sortie connectée à la sortie de multiplexeur, et une grille de commande connectée pour activer la deuxième grille de transmission lorsque le signal d'entrée de mode de lecture se trouve dans un deuxième état logique.

3. Dispositif de mémoire flash non volatile selon la revendication 1 ou 2, en outre comprenant un registre de mode programmable pour générer le signal d'entrée de mode de lecture.

4. Dispositif de mémoire flash non volatile selon la revendication 3, dans lequel le registre de mode programmable est programmable en réponse à une commande de registre de mode reçue par le dispositif lors du fonctionnement, le registre de mode programmable ayant logique de réinitialisation pour ajuster l'état de registre dès que le dispositif est allumé.

5. Dispositif de mémoire flash non volatile selon l'une quelconque des revendications 1 à 4, en outre comprenant un circuit de commande de sortie de données pour recevoir la sortie du multiplexeur et pour générer le signal d'autorisation de sortie.

6. Dispositif de mémoire flash non volatile selon la revendication 5, présentant la capacité d'exécuter des opérations de lecture de registre et des opérations de lecture de matrice de données, dans lequel le circuit de commande de sortie de données permet le signal d'autorisation de sortie de répondre à la sortie du multiplexeur aussi bien lorsque une lecture de registre est demandée que lorsque une lecture de matrice est demandée et des données de matrice sont prêtes à être sorties comme signal de sortie de données.

7. Dispositif de mémoire flash non volatile selon l'une quelconque des revendications 1 à 6, en outre comprenant un tampon d'autorisation de lecture pour affirmer le signal d'autorisation de lecture lorsque un signal d'autorisation d'un chip externe et un signal d'autorisation de lecture externe sont tous deux affirmés.

8. Dispositif de mémoire flash non volatile selon l'une quelconque des revendications 1 à 5, en outre comprenant :
un circuit de mode programmable (290) pour générer le signal d'entrée de mode de lecture apte à indiquer au moins deux modes de lecture, comportant un mode de lecture en pipeline et un mode de lecture non en pipeline ; et
un circuit de commande (300) pour générer un signal d'autorisation de sortie basé sur le signal d'entrée de mode de lecture et le signal d'autorisation de lecture, dans lequel dans le mode de lecture non en pipeline une déassertion du signal d'autorisation de sortie est déclenchée en réponse à une déassertion du signal d'autorisation de lecture, et dans lequel dans le mode de lecture en pipeline une déassertion du signal d'autorisation de sortie est déclenchée par le signal d'autorisation de lecture restant déaffirmé pendant le temps de maintien.

9. Dispositif de mémoire flash non volatile selon la revendication 8, dans lequel le circuit de mode programmable est programmable par le biais de commandes d'ajustage de registre de mode reçues par le dispositif de mémoire non volatile lors du fonctionnement.

10. Dispositif de mémoire flash non volatile selon la revendication 8 ou 9, dans lequel le circuit de mode programmable fait défaut à générer un signal d'entrée de mode de lecture indiquant le mode de lecture non en pipeline dès que le dispositif de mémoire flash est allumé ou fait défaut à générer un signal d'entrée de mode de lecture indiquant le mode de lecture en pipeline dès que le dispositif de mémoire flash est allumé.

11. Système de mémoire comprenant:
un contrôleur de mémoire ayant une sortie d'autorisation de lecture qui est affirmé à un dispositif pour provoquer le dispositif à transmettre des données de lecture au contrôleur de mémoire ;
un bus mémoire multiplexé pour transmettre des données d'adressage, de commande et à écrire du contrôleur de mémoire et pour transmettre des données de lecture au contrôleur de mémoire ; et
un dispositif de mémoire flash non volatile (200-1) selon l'une quelconque des revendications 1 à 10 connecté au bus mémoire multiplexé et au signal de sortie d'autorisation de lecture, et ayant un mode de lecture en salves en pipeline ; dans lequel
le dispositif de mémoire flash est configuré pour transmettre des données de lecture *n* au contrôleur de mémoire jusqu'à un temps ajusté après avoir reçu une (*n*+1)-ème assertion de la sortie d'autorisation de lecture, à quel temps le dispositif de mémoire flash commence à transmettre des données de lecture *n*+1 au contrôleur de mémoire, et
le dispositif de mémoire flash est configuré pour arrêter de transmettre des données de lecture *n* au contrôleur de mémoire et relâche le bus mémoire multiplexé lorsque une (*n*+1)-ème assertion de la sortie d'autorisation de lecture n'est pas reçu pendant un temps de maintien après la *n*-ème déassertion de la sortie d'autorisation de lecture.

12. Système de mémoire selon la revendication 11, dans lequel le dispositif de mémoire flash présente une matrice de mémoire comportant une structure de matrice de noeud de stockage NAND.

13. Système de mémoire selon la revendication 11 or 12, dans lequel le dispositif de mémoire flash présente aussi un mode de lecture en salves non en pipeline, dans lequel le dispositif de mémoire flash présente la capacité de fonctionner dans l'un ou l'autre des modes de lecture en salves en pipeline ou non en pipeline.

14. Système de mémoire selon la revendication 13, dans lequel le contrôleur de mémoire présente la capacité de transmettre des commandes au dispositif de mémoire flash pour sélectionner l'un ou l'autre des modes de lecture en salves en pipeline ou non en pipeline.

15. Système de mémoire selon la revendication 13 ou 14, dans lequel le dispositif de mémoire flash fait défaut du mode de lecture en salves non en pipeline dès qu'il est allumé ou fait défaut du mode de lecture en salves en pipeline dès qu'il est allumé.

16. Procédé de fonctionnement d'un dispositif de mémoire flash, ledit dispositif de mémoire flash comprenant un tampon de sortie (260) pour fournir un signal de sortie de données en réponse à une assertion d'un signal d'autorisation de lecture, un circuit de jugement (320) pour affirmer un signal de flag de sortie en réponse à l'assertion du signal d'autorisation de lecture, le circuit de jugement pour déaffirmer le signal de flag de sortie lorsque le signal d'autorisation de lecture reste déaffirmé pendant au moins un temps de maintien, un driver de sortie tri-état (400) accouplé au signal de sortie de données et un signal d'autorisation de sortie, ledit driver de sortie tri-état conduisant et configuré pour conduire le signal de sortie de données sur un noeud de sortie lorsque le signal d'autorisation de sortie est affirmé, et présentant une haute impédance au noeud de sortie autrement, et un multiplexeur (330), le procédé comprenant:
dans un premier mode de lecture, en réponse à une première assertion d'autorisation de lecture, conduire un mot de données demandé à une sortie de dispositif de mémoire flash jusqu'à une deuxième assertion d'autorisation de lecture provoque le dispositif à conduire un mot de données demandé suivant sur la sortie du dispositif de mémoire flash, là où la sortie du dispositif de mémoire flash est mise dans un état de haute impédance à la déassertion de la deuxième assertion d'autorisation de lecture, et
dans un deuxième mode de lecture, en réponse à une première assertion d'autorisation de lecture, conduire un mot de données demandé à une sortie de dispositif de mémoire flash jusqu'à une deuxième assertion d'autorisation de lecture provoque le dispositif à conduire un mot de données demandé suivant sur la sortie du dispositif de mémoire flash, là où la sortie du dispositif de mémoire flash est mise dans un état de haute impédance à l'expiration d'un temps de maintien après la déassertion de la deuxième (*n*-ème) assertion d'autorisation de lecture.

17. Procédé selon la revendication 16, en outre comprenant sélectionner le premier ou le deuxième mode de lecture en réponse à une commande d'ajustage de registre de mode.

18. Procédé selon la revendication 16 ou 17, en outre comprenant sélectionner le deuxième mode de lecture comme mode de défaut dès que le dispositif est allumé.

19. Procédé de fonctionnement d'un système de mémoire selon l'une quelconque des revendications 11 à 15, le procédé comprenant faire fonctionner le dispositif de mémoire flash par le procédé selon l'une quelconque des revendications 16 à 18 de telle manière que
le contrôleur de mémoire affirme un signal d'autorisation de lecture un n-ème temps au dispositif de mémoire flash ;
le contrôleur de mémoire déaffirme le signal d'autorisation de lecture un n-ème temps;
le dispositif de mémoire flash met des données de lecture n sur le bus en réponse à l'assertion de signal d'autorisation de lecture *n ;*
le contrôleur de mémoire affirme le signal d'autorisation de lecture un (*n*+1)-ème temps au dispositif de mémoire flash et lecture de données de lecture *n* du bus ;
le contrôleur de mémoire déaffirme le signal d'autorisation de lecture un (*n*+1)-ème temps ;
le dispositif de mémoire flash remplace des données de lecture *n* de données de lecture *n*+1 sur le bus en réponse à l'assertion de signal d'autorisation de lecture *n*+1;
le contrôleur de mémoire lit des données de lecture *n*+1 du bus ; et
le dispositif de mémoire flash enlève des données de lecture *n*+1 du bus et met la connexion du dispositif au bus dans un état de haute impédance un temps de maintien après avoir reçu la déassertion de signal d'autorisation de lecture *n*+1.

20. Procédé selon la revendication 19, en outre comprenant des assertions et déassertions de signal d'autorisation de lecture supplémentaires convenant à les *n-*èmes et (*n*+1)-èmes assertions et déassertions dans une opération de lecture en salves commune.

21. Procédé selon la revendication 19 ou 20, en outre comprenant:
initier un commandement au contrôleur de mémoire un certain temps avant la *n-*ème assertion de signal d'autorisation de lecture pour demander un mode d'opération de lecture en pipeline ; et
configurer le dispositif de mémoire pour fonctionner selon la revendication 18 en réponse au commandement.
